# EUROPEAN PATENT SPECIFICATION

(11) **EP 3 279 262 B1**
(45) Date of publication and mention of the grant of the patent: **08.11.2023**
(21) Application number: 16772710.6
(22) Date of filing: 28.03.2016
(51) Int. Cl.: C08L 61/34, C08G 14/073, C08G 59/56, C08G 73/00, C08G 73/12, C08L 63/00, C09J 9/02, C09J 11/00, C09J 161/34, C09J 179/04, H01L 21/288, C08L 79/02

(54) **RESIN COMPOSITION, ELECTROCONDUCTIVE RESIN COMPOSITION, ADHESIVE, ELECTROCONDUCTIVE ADHESIVE, PASTE FOR FORMING ELECTRODES, AND SEMICONDUCTOR DEVICE**
HARZZUSAMMENSETZUNG, ELEKTRISCH LEITENDE HARZZUSAMMENSETZUNG, KLEBSTOFF, ELEKTRISCH LEITENDER KLEBSTOFF, PASTE ZUR HERSTELLUNG VON ELEKTRODEN UND HALBLEITERBAUELEMENT
COMPOSITION DE RÉSINE, COMPOSITION DE RÉSINE ÉLECTROCONDUCTRICE, ADHÉSIF, ADHÉSIF ÉLECTROCONDUCTEUR, PÂTE POUR FORMER DES ÉLECTRODES, ET DISPOSITIF À SEMI-CONDUCTEUR

(30) Priority: 31.03.2015 JP 2015071468
(43) Date of publication of application: 07.02.2018
(73) Proprietor: Namics Corporation, Niigata-shi, Niigata 950-3131 (JP)
(72) Inventor: YAMAGUCHI, Takashi, Niigata-shi Niigata 950-3131 (JP); ABE, Shinichi, Niigata-shi Niigata 950-3131 (JP)
(74) Representative: Zimmermann, Tankred Klaus
(86) International application number: PCT/JP2016/059843
(87) International publication number: WO 2016/158829

(56) References cited:
- WO-A1-2015/024256
- WO-A2-2004/037878
- CN-A- 102 208 538
- JP-A- S5 224 289
- JP-A- 2010 150 463
- JP-A- 2010 260 971
- JP-A- 2013 001 853
- JP-A- 2014 141 603
- US-A1- 2014 023 839
- US-A1- 2014 323 624

## Description

### TECHNICAL FIELD

The present invention relates to a resin composition, a conductive resin composition, an adhesive, a conductive adhesive, a paste for forming electrodes, and a semiconductor device.

### BACKGROUND ART

A resin composition is used as a sealing material or an adhesive for a wiring board, a circuit board, a circuit plate including multiple layers of wiring boards and circuit boards, a semiconductor chip, a coil, an electrical circuit, an automobile component, and the like. Such a resin composition is required to have heat resistance.

A resin composition having excellent heat resistance is widely known. For example, JP 2012-97207 A discloses a polybenzoxazine-modified bismaleimide resin composition having excellent heat resistance, which includes benzoxazine and bismaleimide. JP 2012-97207 A also discloses an example in which imidazole is contained as a curing accelerator.

JP2014-227542 A discloses a resin composition which includes a bismaleimide compound and a benzoxazine compound, as well as a triazine compound used as a curing accelerator. It is disclosed that such a resin composition has excellent heat resistance.

US 2014/023839 A1 discloses a halogen-free resin composition includes (A) 100 parts by weight of epoxy resin; (B) 10 to 100 parts by weight of benzoxazine resin; (C) 5 to 50 parts by weight of diallylbisphenol A resin; and (D) 0.05 to 20 parts by weight of an amine curing agent.

### SUMMARY OF THE INVENTION

### PROBLEMTS TO BE SOLVED BY THE INVENTION

Here, when the resin composition is used, it is required to have high adhesive strength during heating as well as heat resistance. In particular, it is preferable that the change ratio in adhesive strength between during normal temperature and during heating (the change ratio of adhesive strength) be low.

An object of the present invention is to provide a resin composition, a conductive resin composition, an adhesive, a conductive adhesive, a paste for forming electrodes, and a semiconductor device, which have long-term heat resistance and a low change ratio of adhesive strength.

### SOLUTION TO THE PROBLEMS

The present inventor found that a resin composition including a compound having in its molecule an OH group and any one of primary to tertiary amines, dicyandiamide, and bismaleimides has long-term heat resistance and a low change ratio of adhesive strength. The present invention has been accomplished based on these findings.

The present invention is a resin composition, a conductive resin composition, an adhesive, a conductive adhesive, a paste for forming electrodes, and a semiconductor device, which solve the above-described problems by having the following configurations.
[1] A resin composition including a compound A having in its molecule an OH group and any one of primary to tertiary amines, wherein A is a compound having a benzoxazine backbone, compound B being dicyandiamide, and compound C being bismaleimides, in which C is liquid bismaleimides.
[2] The resin composition according to the above-described [1], further including (D) a compound having in its molecule one or more epoxy groups, or cyanate ester.
[3] A conductive resin composition including the resin composition according to any one of the above-described [1] to [2], and a conductive filler.
[4] An adhesive including the resin composition according to any one of the above-described [1] to [2].
[5] A conductive adhesive including the conductive resin composition according to the above-described [3].
[6] A paste for forming electrodes including the conductive resin composition according to the above-described [3].
[7] A semiconductor device including: a cured product of the resin composition according to any one of the above-described [1] to [3];; a cured product of the adhesive according to the above-described [4]; a cured product of the conductive adhesive according to the above-described [5]; or a cured product of the paste for forming electrodes according to the above-described [6].

### EFFECTS OF THE INVENTION

The resin composition according to the present invention has long-term heat resistance and a low change ratio of adhesive strength.

### BRIEF DESCRIPTION OF THE DRAWINGS

Fig. 1 is a graph illustrating a relationship between adhesive strength and a curing time of a resin composition.
Fig. 2 is a graph illustrating a relationship between adhesive strength and a curing time of a resin composition.

### DESCRIPTION OF THE EMBODIMENTS

The resin composition according to the present invention includes a compound A having in its molecule an OH group and any one of primary to tertiary amines, wherein A is a compound having a benzoxazine backbone, a cpompound B being dicyandiamide, and a compound C being bismaleimides, , wherein C is liquid bismaleimides.

As described herein, "normal temperature" refers to 20°C ±15°C. Being "liquid" refers to having fluidity at normal temperature. Being "solid" refers to not having fluidity at normal temperature. The "weight loss" is the change ratio of weight Y relative to weight X. Here, weight X is a weight of a cured product of the resin composition, and weight Y is a weight of the cured product which has been left to stand at a predetermined temperature for a predetermined period of time (for example, 200°C × 100 hours). Specifically, the weight loss is a value indicated by "weight loss = ((weight X- weight Y|/weight X) × 100." "Having long-term heat resistance" refers to being low in weight loss. "Adhesive strength" refers to strength with which the resin composition causes a certain object (for example, an alumina test piece) to be adhered. A "change ratio of adhesive strength" is a ratio between the adhesive strength during normal temperature and the adhesive strength during heating. Specifically, the change ratio of adhesive strength is a value indicated by "change ratio of adhesive strength = (|adhesive strength at 200°C - adhesive strength at normal temperature|/adhesive strength at normal temperature) × 100." It can be said that the lower the change ratio of adhesive strength is, the higher heat resistance is.

### [Compound Having in its Molecule an OH Group and Any One of Primary to Tertiary Amines]

Examples of the compound having in its molecule an OH group and any one of primary to tertiary amines may include a compound having a benzoxazine backbone, and aminophenols. From the viewpoint of long-term heat resistance, a compound according to the present invention is having a benzoxazine backbone, such as benzoxazine as a highly heat resistant resin. It is noted that as described herein, "having in its molecule an OH group" includes not only having in its molecule an OH group itself, like phenols, but also having in its molecule an OH group through ring opening, like benzoxazine.

### [Dicyandiamide]

Dicyandiamide ("DICY") is an amide compound represented by H₂N-CNH-NH-CN. Dicyandiamide acts as a curing agent to bismaleimides when synthesizing the resin composition according to the present invention. Also, dicyandiamide acts as a catalyst in the reaction between the compound having in its molecule an OH group and any one of primary to tertiary amines, and bismaleimides. Dicyandiamide is a compound widely used in industrial applications, and is excellent in adhesiveness, heat resistance, and the like.

### [Bismaleimides]

Examples of bismaleimides may include N,N'-(4,4'-diphenylmethane)bismaleimide, bisphenol A diphenyl ether bismaleimide, 3,3'-dimethyl-5,5'-diethyl-4,4'-diphenylmethane bismaleimide, 4-methyl-1,3-phenylene bismaleimide, 1,6'-bismaleimide-(2,2,4-trimethyl)hexane, bis-(3-ethyl-5-methyl-4-maleimidephenyl)methane, m-phenylene bismaleimide (N,N'-1,3-phenylene bismaleimide), 1,6-bismaleimide hexane, 1,2-bismaleimide ethane (N,N'-ethylenedimaleimide), N,N'-(1,2-phenylene)bismaleimide, N,N'-1,4-phenylene dimaleimide, N,N'-(sulfonyldi-p-phenylene)dimaleimide, and N,N'-[3,3'-(1,3-phenylenedioxy)diphenyl]bismaleimide.

The bismaleimides in the present invention include liquid bismaleimides. Solid bismaleimides generally have low solubility to organic solvents. Therefore, when solid bismaleimides are used, a large amount of organic solvents needs to be used for dilution. However, in this case, solvents volatilize during curing, causing formation of a void, which leads to the decrease of adhesive strength and the occurrence of cracks. In order to prevent this, a method of dispersing solid bismaleimides in the resin composition using a roll mill or the like can be also adopted. However, this method causes the viscosity of the resin composition to increase. On the other hand, the resin composition according to the present invention is containing liquid bismaleimides which has low viscosity. Therefore, workability when using the resin composition improves.

Also, dimer acid-modified bismaleimides can be used. Examples of dimer acid-modified bismaleimides include BMI-1500 and BMI-1700 as liquid bismaleimides, and BMI-3000 as solid bismaleimides (all are manufactured by Designer molecules Inc.). The use of dimer acid-modified bismaleimides enables the elastic modulus of the resin composition to be suppressed low. It is considered that this is because dimer acid-modified bismaleimides have a reactive maleimide group only at both terminals, and therefore do not have a crosslinkable reactive group in its molecular chain. In a cured product of such a resin composition, cracks are unlikely to occur.

### [Manufacturing Method of Resin Composition]

The resin composition according to the present invention can be manufactured by mixing a compound A having in its molecule an OH group and any one of primary to tertiary amines, wherein A is a compound having a benzoxazine backbo, a compound B dicyandiamide, and a compound C being bismaleimides, wherein C is liquid bismaleimides. The manufacturing method of the resin composition is not particularly limited, as long as a composition in which the above-described components are uniformly mixed can be obtained.

### [Compound Having in its Molecule One or More Epoxy Groups, or Cyanate Ester]

The resin composition according to the present invention may include D a compound D having in its molecule one or more epoxy groups, or cyanate ester.

An example of the compound having in its molecule one or more epoxy groups includes epoxy resin. Examples of epoxy resin may include bisphenol A-type epoxy resin, brominated bisphenol A-type epoxy resin, bisphenol F-type epoxy resin, biphenyl-type epoxy resin, Novolac-type epoxy resin, alicyclic epoxy resin, naphthalene-type epoxy resin, ether-based epoxy resin, polyether-based epoxy resin, oxirane ring-containing polybutadiene, and silicone epoxy copolymer resin.

Also, examples of liquid epoxy resin may include bisphenol A-type epoxy resin having an average molecular weight of approximately 400 or less, branched multifunctional bisphenol A-type epoxy resin such as p-glycidyloxyphenyl dimethyl tris bisphenol A diglycidyl ether, bisphenol F-type epoxy resin, phenol Novolac-type epoxy resin having approximately 570 or less, alicyclic epoxy resin such as vinyl(3,4-cyclohexene)dioxide, 3,4-epoxy cyclohexyl carboxylic acid (3,4-epoxy cyclohexyl)methyl, bis(3,4-epoxy-6-methylcyclohexylmethyl) adipate, and 2-(3,4-epoxycyclohexyl)5, 1-spiro(3,4-epoxycyclohexyl)-m-dioxane, biphenyl-type epoxy resin such as 3,3',5,5'-tetramethyl-4,4'-diglycidyloxybiphenyl, glycidyl ester-type epoxy resin such as diglycidyl hexahydrophthalate, diglycidyl 3-methylhexahydrophthalate, and diglycidyl hexahydroterephthalate, glycidyl amine-type epoxy resin such as diglycidyl aniline, diglycidyl toluidine, triglycidyl-p-aminophenol, tetraglycidyl-m-xylylenediamine, and tetraglycidyl bis(aminomethyl)cyclohexane, hydantoin-type epoxy resin such as 1,3-diglycidyl-5-methyl-5-ethylhydantoin, and naphthalene ring-containing epoxy resin. Also, epoxy resin having a silicone backbone such as 1,3-bis(3-glycidoxypropyl)-1,1,3,3-tetramethyldisiloxane can be used. Further examples may include diepoxide compounds such as (poly)ethylene glycol diglycidyl ether, (poly)propylene glycol diglycidyl ether, butanediol glycidyl ether, and neopentyl glycol diglycidyl ether, and triepoxide compounds such as trimethylol propane triglycidyl ether and glycerin triglycidyl ether.

Examples of solid epoxy resin may include orthocresol Novolac-type epoxy resin, phenol Novolac-type epoxy resin, naphthol Novolac-type epoxy resin, modified phenol-type epoxy resin, naphthalene-type epoxy resin, dicyclopentadiene-type epoxy resin, glycidyl amine-type epoxy resin, biphenyl-type epoxy resin, bisphenol A-type epoxy resin, biphenyl aralkyl-type epoxy resin, bisphenol F-type epoxy resin, hydrogenated bisphenol A-type epoxy resin, aliphatic-type epoxy resin, stilbene-type epoxy resin, and bisphenol A Novolac-type epoxy resin, which have a high molecular weight.

One kind of epoxy resin can be used alone. Alternatively, two or more kinds of epoxy resin can be mixed and used. Also, dimer acid-modified epoxy resin can be used. An example of dimer acid-modified epoxy resin may include jER871 (manufactured by Mitsubishi Chemical Corporation). The use of dimer acid-modified epoxy resin enables the elastic modulus of the resin composition to be suppressed low. In a cured product of such a resin composition, cracks are unlikely to occur.

### [Others]

A conductive material such as a conductive filler may be added to the resin composition, so that the resin composition has conductivity. Examples of the conductive filler may include an Ag filler, an AgSn filler, and an alloy filler thereof. From the viewpoint of conductivity, the conductive material is preferably 19 to 65% by volume (equivalent to 70 to 95% by weight for an Ag filler or the like having a specific gravity of approximately 10), and further preferably 23 to 48% by volume (equivalent to 75 to 90% by weight for an Ag filler or the like having a specific gravity of approximately 10). The resin composition having conductivity (conductive resin composition) is used when an electrical connection is required in a circuit board, an electrical circuit, and the like. Also, a thermally conductive material such as Ag and alumina may be added to the resin composition, so that the resin composition has thermal conductivity. The resin composition having thermal conductivity is used when the heat from a chip or a substrate is required to be released. Furthermore, a silica filler or a silicone powder may be added as a filling material to the resin composition. The addition of the filling material such as the silicone powder leads to lowering of elasticity. Also, an additive or the like such as a silane coupling agent may be contained as necessary, within the range that does not impair the effects of the present invention.

### [Adhesive and Semiconductor Device]

The resin composition according to the present invention can be used as an adhesive. An adhesive is used for bonding to a circuit of an electronic component, or as a die attacher which bonds a semiconductor element and another semiconductor element, and/or as a die attacher which bonds a semiconductor element and a support member for mounting the semiconductor element. When the adhesive is a conductive adhesive, it can be used as an alternative to solder. Also, a semiconductor device has a structure in which a semiconductor element and another semiconductor element are bonded together, and/or a structure in which a semiconductor element and a support member for mounting the semiconductor element are bonded together. A semiconductor device which includes a cured product of the resin composition according to the present invention or a cured product of the adhesive according to the present invention is excellent in reliability at a high temperature of 200°C.

### EXAMPLES

### [Influence by Variation of Catalyst on Long-Term Heat Resistance and Change Ratio of Adhesive Strength]

The long-term heat resistance, adhesive strength (normal temperature and 200°C), and the like of the resin compositions obtained in Examples 1 to 8 and Comparative Examples 1 to 6 described below were calculated.

As a compound A having in its molecule an OH group and any one of primary to tertiary amines, , wherein A is a compound having a benzoxazine backbone (hereinafter, sometimes referred to as an "(A) component"), there was used a 66% solution prepared by diluting "F-a type benzoxazine" or "P-d type benzoxazine" (both manufactured by Shikoku Chemicals Corporation) with butyl carbitol acetate (hereinafter, sometimes referred to as "BCA").

As compound B being dicyandiamide (hereinafter, sometimes referred to as a "(B) component"), any one of the followings was used.
- "EH-3636AS" (DICY 100%) manufactured by Adeka Corporation
- "EH-3842" (DICY 64%, accelerator 36%) manufactured by Adeka Corporation

Also, in Comparative Examples, any one of the following catalysts or curing agents was used instead of the (B) component (indicated as (B') in Table 1).

### <Imidazole (IMZ)>

- "2PHZ-PW" (2-phenyl-4,5-dihydroxymethylimidazole) manufactured by Shikoku Chemicals Corporation
- "2P4MHZ-PW" (2-phenyl-4-methyl-5-hydroxymethylimidazole) manufactured by Shikoku Chemicals Corporation

### <Acid Anhydride>

- "YH-307" manufactured by Mitsubishi Plastics Inc.

### <Amine-Based Curing Agent>

- "DDH" (dodecanediohydrazide) manufactured by Tokyo Chemical Industry Co., Ltd.

### <Chelate Agent (Metal Curing Catalyst)>

- "aluminum chelate-M (AL-M)" (aluminum alkyl acetoacetate-diisopropylate) Kawaken Fine Chemicals Co., Ltd.

As compound C being bismaleimides (hereinafter, sometimes referred to as a "(C) component"), any one of the followings was used.
- "BMI" (solid, 4,4'-diphenylmethane bismaleimide not covered by the present invention) manufactured by K.I Chemical Industry Co., Ltd.
- "BMI-1500" (liquid, dimer acid-modified covered by the present invention) manufactured by Designer molecules Inc.
- "BMI-1700" (liquid, dimer acid-modified covered by the present invention) manufactured by Designer molecules Inc.
- "BMI-3000" (solid, dimer acid-modified not covered by the present invention) manufactured by Designer molecules Inc.

### (Example 1)

Into a container, there were poured 2 parts (solid content: 1.33 parts) of a 66% solution of "F-a type benzoxazine," 0.3 parts of "EH-3636AS," and 0.15 parts of "BMI." The mixture was hand-stirred. Thereafter, the obtained product was dispersed using a triple roll mill, thereby to prepare a resin composition a.

### (Example 2)

Into a container, there were poured 2 parts (solid content: 1.33 parts) of a 66% solution of "F-a type benzoxazine," 0.3 parts of "EH-3636AS," and 1 part of "BMI-1500." The mixture was hand-stirred. Thereafter, the obtained product was dispersed using a triple roll mill, thereby to prepare a resin composition b.

### (Example 3)

Into a container, there were poured 2 parts (solid content: 1.33 parts) of a 66% solution of "F-a type benzoxazine," 0.3 parts of "EH-3636AS," and 1 part of "BMI-1700." The mixture was hand-stirred. Thereafter, the obtained product was dispersed using a triple roll mill, thereby to prepare a resin composition c.

### (Example 4)

Into a container, there were poured 2 parts (solid content: 1.33 parts) of a 66% solution of "F-a type benzoxazine," 0.3 parts of "EH-3636AS," and 1 part of "BMI-3000." The mixture was hand-stirred. Thereafter, the obtained product was dispersed using a triple roll mill, thereby to prepare a resin composition d.

### (Example 5)

Into a container, there were poured 2 parts (solid content: 1.33 parts) of a 66% solution of "F-a type benzoxazine," 0.3 parts of "EH-3842," and 1 part of "BMI-1500." The mixture was hand-stirred. Thereafter, the obtained product was dispersed using a triple roll mill, thereby to prepare a resin composition e.

### (Example 6)

Into a container, there were poured 3 parts (solid content: 2 parts) of a 66% solution of "F-a type benzoxazine," 0.6 parts of "EH-3636AS," and 1.5 parts of "BMI-1500." The mixture was hand-stirred. Thereafter, the obtained product was dispersed using a triple roll mill, thereby to prepare a resin composition f.

### (Example 7)

Into a container, there were poured 4 parts (solid content: 2.66 parts) of a 66% solution of "F-a type benzoxazine," 0.6 parts of "EH-3636AS," 1.5 parts of "BMI," and 1 part of "BMI-1500." The mixture was hand-stirred. Thereafter, the obtained product was dispersed using a triple roll mill, thereby to prepare a resin composition g.

### (Example 8)

Into a container, there were poured 2 parts (solid content: 1.33 parts) of a 66% solution of "P-d type benzoxazine," 0.3 parts of "EH-3636AS," and 1 part of "BMI-1500." The mixture was hand-stirred. Thereafter, the obtained product was dispersed using a triple roll mill, thereby to prepare a resin composition h.

### (Comparative Example 1)

Into a container, there were poured 2 parts (solid content: 1.33 parts) of a 66% solution of "F-a type benzoxazine," 0.1 parts of "2PHZ-PW," and 1 part of "BMI." The mixture was hand-stirred. Thereafter, the obtained product was dispersed using a triple roll mill, thereby to prepare a resin composition α.

### (Comparative Example 2)

Into a container, there were poured 2 parts (solid content: 1.33 parts) of a 66% solution of "F-a type benzoxazine," 0.1 parts of "2PHZ-PW," and 1 part of "BMI-1500." The mixture was hand-stirred. Thereafter, the obtained product was dispersed using a triple roll mill, thereby to prepare a resin composition β.

### (Comparative Example 3)

Into a container, there were poured 2 parts (solid content: 1.33 parts) of a 66% solution of "F-a type benzoxazine," 0.1 parts of "2P4MHZ-PW," and 1 part of "BMI-1500." The mixture was hand-stirred. Thereafter, the obtained product was dispersed using a triple roll mill, thereby to prepare a resin composition γ.

### (Comparative Example 4)

Into a container, there were poured 2 parts (solid content: 1.33 parts) of a 66% solution of "F-a type benzoxazine," 1 part of "YH-307," and 1 part of "BMI-1500." The mixture was hand-stirred. Thereafter, the obtained product was dispersed using a triple roll mill, thereby to prepare a resin composition δ.

### (Comparative Example 5)

Into a container, there were poured 2 parts (solid content: 1.33 parts) of a 66% solution of "F-a type benzoxazine," 1 part of "DDH," and 1 part of "BMI-1500." The mixture was hand-stirred. Thereafter, the obtained product was dispersed using a triple roll mill, thereby to prepare a resin composition ε.

### (Comparative Example 6)

Into a container, there were poured 2 parts (solid content: 1.33 parts) of a 66% solution of "F-a type benzoxazine," 0.1 parts of "AL-M," and 1 part of "BMI-1500." The mixture was hand-stirred. Thereafter, the obtained product was dispersed using a triple roll mill, thereby to prepare a resin composition ζ.

### (Calculation of Long-Term Heat Resistance)

The long-term heat resistance was calculated as follows. First, similarly to the measurement of curing properties, the resin composition was cured thereby to prepare a plate-like cured film. Then, the weight of the cured film was measured. Next, the cured film was left to stand in an oven ("DF411" manufactured by Yamato Scientific Co., Ltd.) set at 200°C for 100 hours. Then, the weight of the cured film which has been left to stand was measured. Then, the weight loss was calculated based on the weight of the cured film before having been left to stand and the weight of the cured film after having been left to stand.

In the calculation results, the weight loss of less than 8% was evaluated as "Good," indicting excellent long-term heat resistance. The weight loss of 8 to 12% was evaluated as "Fair." Furthermore, the weight loss of 12% or more was evaluated as "Poor."

### (Measurement of Adhesive Strength)

Using a #200 mesh screen mask having openings of 1.5-mm square × 25, the resin composition was applied onto a 20-mm square alumina substrate. Then, there was prepared a test piece having ten 3.2 mm × 1.6 mm-size alumina chips mounted on ten of the 25 print patterns. Next, the resin composition was cured in the curing condition of "200°C in temperature, 30 minutes." The shear strength of this test piece was measured using a strength tester (Model No. 1605HTP, manufactured by Aikoh Engineering Co., Ltd.), thereby to calculate adhesive strength at normal temperature.

In the measurement results, the adhesive strength of 30 N/mm² or more was evaluated as "Good," the adhesive strength of 30 to 20 N/mm² was evaluated as "Fair," and the adhesive strength of less than 20 N/mm² was evaluated as "Poor."

Also, the above-described test piece having been cured in the curing condition of "200°C in temperature, 30 minutes" was heated on a hot plate at 200°C for one minute or more. In this state, the shear strength of this test piece was measured using a strength tester (same as the above). Thus, the adhesive strength at 200°C (adhesive strength during heating) was calculated.

In the measurement results, the adhesive strength of 7 N/mm² or more was evaluated as "Good," the adhesive strength of 7 to 5 N/mm² was evaluated as "Fair," and the adhesive strength of less than 5 N/mm² was evaluated as "Poor."

Furthermore, the change ratio of adhesive strength in the resin composition was calculated based on the value of adhesive strength at normal temperature and the value of adhesive strength at 200°C.

In the calculation results, the change ratio of less than 85% was evaluated as "Good," and the change ratio of 85% or more was evaluated as "Poor."

In the comprehensive evaluation of the above-described measurement and calculation results, the resin composition was evaluated as "Excellent" when all results were "Good," "Good" when one of the results was "Fair," and "Poor" when one or more of the results were "Poor." The resin composition evaluated as "Excellent" or "Good" in the comprehensive evaluation is the resin composition according to the present invention.

**[Tabl e 1 ]**

| Component | Formulation [parts] * Converted into solid content | Example 1 (Resin composition a) | Example 2 (Resin composition b) | Example 3 (Resin composition c) | Example 4 (Resin composition d) | Example 5 (Resin composition e) | Example 6 (Resin composition f) | Example 7 (Resin composition 9) | Example 8 (Resin composition h) | Comparative Example 1 (Resin composition α) | Comparative Example 2 (Resin composition β) | Comparative Example 3 (Resin composition γ) | Comparative Example 4 (Resin composition δ) | Comparative Example 5 (Resin composition ε) | Comparative Example 6 (Resin composition ζ) |
|---|---|---|---|---|---|---|---|---|---|---|---|---|---|---|---|
| (A) | F-a type benzoxazine | 1.33 | 1.33 | 1.33 | 1.33 | 1.33 | 2 | 2.66 | | 1.33 | 1.33 | 1.33 | 1.33 | 1.33 | 1.33 |
| | P-d type benzoxazine | | | | | | | | 1.33 | | | | | | |
| (B) | EH-3636AS (DICY) | 0.3 | 0.3 | 0.3 | 0.3 | | 0.6 | 0.6 | 0.3 | | | | | | |
| | EH-3842 (DICY + accelerator) | | | | | 0.3 | | | | | | | | | |
| (B') | 2PHZ-PW (IMZ) | | | | | | | | | 0.1 | 0.1 | | | | |
| | Aluminum chelate-M | | | | | | | | | | | | | | 0.1 |
| | 2P4MHZ-PW (IMZ) | | | | | | | | | | | 0.1 | | | |
| | DDH (amine-based curing agent) | | | | | | | | | | | | | 1 | |
| | YH-307 (acid anhydride) | | | | | | | | | | | | 1 | | |
| (C) | BMI (solid) | 1 | | | | | | 1.5 | | 1 | | | | | |
| | "BMI-1500" (liquid/ dimer acid-modified) | | 1 | | | 1 | 1.5 | 1 | 1 | | 1 | 1 | 1 | 1 | 1 |
| | "BMI-1700" (liquid/ dimer acid-modified) | | | 1 | | | | | | | | | | | |
| | "BMI-3000" (solid/ dimer acid-modified) | | | | 1 | | | | | | | | | | |
| Measurment results | Heat resistance (weight loss) [%] | Good (0.2) | Good (5.8) | Good (6.0) | Good (4.8) | Good (5.8) | Good (7.5) | Good (4.3) | Good (7.2) | Good (1.0) | Poor (12.9) | Fair (8.4) | Fair (10.8) | Good (5.7) | Fair (9.0) |
| | Adhesive strength (Normal temperature) [N/mm²] | Good (49.4) | Good (44.5) | Good (49.5) | Good (33.7) | Good (43.0) | Good (44.5) | Good (65.1) | Good (48.5) | Good (50.0) | Good (47.6) | Good (46.2) | Fair (28.8) | Good (45.7) | Good (41.4) |
| | Adhesive strength (200°C) [N/mm²] | Good (200) | Good (7.2) | Good (12.4) | Good (9.0) | Good (10.8) | Good (7.7) | Good (13.3) | Good (13.5) | Fair (6.4) | Fair (5.0) | Fair (5.7) | Poor (0.5) | Fair (5.3) | Poor (0.3) |
| | Strength change ratio (%) | Good (59.5) | Good (83.8) | Good (74.9) | Good (73.3) | Good (74.9) | Good (82.7) | Good (79.6) | Good (72.2) | Poor (87.2) | Poor (89.5) | Poor (87.7) | Poor (98.3) | Poor (88.4) | Poor (99.3) |
| | Comprehensive evaluation | Excellent | Excellent | Excellent | Excellent | Excellent | Excellent | Excellent | Excellent | Poor | Poor | Poor | Poor | Poor | Poor |

As indicated in Table 1, there was obtained the result that the resin compositions according to Examples 1 to 8 also have excellent long-term heat resistance.

Furthermore, there was obtained the result that the resin compositions according to Examples 1 to 8 have roughly high adhesive strength during heating and a low change ratio of adhesive strength, compared to the resin compositions according to Comparative Examples 1 to 6. It is noted that, as obvious from Example 6, there was obtained the result that long-term heat resistance, adhesive strength during heating, and a change ratio of adhesive strength are not influenced by variation of the ratios of the (A) to (C) components. Also, as obvious from Example 7, the use of a combination of solid bismaleimides and liquid bismaleimides as the (C) component further improved adhesive strength. Also, as obvious from Example 8, similar effects were obtained even when benzoxazine which is different from that of other examples was used as the (A) component.

On the other hand, in Comparative Examples 1 to 6 in which a substance other than dicyandiamide was used instead of the (B) component, the resin composition which satisfies all the criteria of long-term heat resistance and a change ratio of adhesive strength was not obtained. In particular, the change ratios of adhesive strength in all of Comparative Examples were lower than the criterion. As obvious from this result, a ternary system (a system including three components of the (A) to (C) components) in which dicyandiamide is used as a catalyst (and a curing agent) has high adhesive strength during heating, and can suppress a change ratio of adhesive strength to be low.

### [Influence by Existence of Additive on Long-Term Heat Resistance and Change Ratio of Adhesive Strength]

The long-term heat resistance, adhesive strength (normal temperature and 200°C), and the like of the resin compositions obtained in Examples 9 to 12 and Comparative Example 7 described below were calculated.

As the (A) component, a 66% solution prepared by diluting "F-a type benzoxazine" with BCA was used. As the (B) component, "EH-3636AS" was used. Also, in Comparative Examples, "2PHZ-PW" was used instead of the (B) component (indicated as (B') in Table 2). As the (C) component, "BMI-1500" was used.

As an additive, any one of the followings was used.
- Ag filler, scaly, tap density 4.0 g/cc, specific surface area 0.6 m²/g
- silicone powder KMP-600 manufactured by Shin-Etsu Chemical Co., Ltd.
- silane coupling agent (3-glycidoxypropyltrimethoxysilane) KBM-403 manufactured by Shin-Etsu Chemical Co., Ltd.

### (Example 9)

Into a container, there were poured 2 parts (solid content: 1.33 parts) of a 66% solution of "F-a type benzoxazine," 0.3 parts of "EH-3636AS," 1 part of "BMI-1500," and 12 parts of an "Ag filler." The mixture was hand-stirred. Thereafter, the obtained product was dispersed using a triple roll mill, thereby to prepare a resin composition i.

### (Example 10)

Into a container, there were poured 2 parts (solid content: 1.33 parts) of a 66% solution of "F-a type benzoxazine," 0.3 parts of "EH-3636AS," 1 part of "BMI-1500," and 0.1 parts of a "silicone powder." The mixture was hand-stirred. Thereafter, the obtained product was dispersed using a triple roll mill, thereby to prepare a resin composition j.

### (Example 11)

Into a container, there were poured 1.33 parts of "F-a type benzoxazine," 0.3 parts of "EH-3636AS," 1 part of "BMI-1500," 12 parts of an "Ag filler," and 0.1 parts of a "silicone powder." Thereafter, the obtained product was dispersed using a triple roll mill, thereby to prepare a resin composition k.

### (Example 12)

Into a container, there were poured 2 parts (solid content: 1.33 parts) of a 66% solution of "F-a type benzoxazine," 0.3 parts of "EH-3636AS," 1 part of "BMI-1500," 12 parts of an "Ag filler," and 0.05 parts of a "silane coupling agent." The mixture was hand-stirred. Thereafter, the obtained product was dispersed using a triple roll mill, thereby to prepare a resin composition 1.

### (Comparative Example 7)

Into a container, there were poured 2 parts (solid content: 1.33 parts) of a 66% solution of "F-a type benzoxazine," 0.1 parts of ""2PHZ-PW"," 1 part of "BMI-1500," and 12 parts of an "Ag filler." The mixture was hand-stirred. Thereafter, the obtained product was dispersed using a triple roll mill, thereby to prepare a resin composition η.

It is noted that the measurement method of long-term heat resistance is the same as that in Example 1 described above.

**[Table 2]**

| Component | Formulation [parts] * Converted into solid content | Example 9 (Resin composition i) | Example 10 (Resin composition j) | Example 11 (Resin composition k) | Example 12 (Resin composition l) | Comparative Example 7 (Resin composition η) |
|---|---|---|---|---|---|---|
| (A) | F-a type benzoxazine | 1.33 | 1.33 | 1.33 | 1.33 | 1.33 |
| (B) | EH-3636AS (DICY) | 0.3 | 0.3 | 0.3 | 0.3 | |
| (B') | 2PHZ-PW (IMZ) | | | | | 0.1 |
| (C) | "BMI-1500" (liquid/ dimer acid-modified) | 1 | 1 | 1 | 1 | 1 |
| Additives | Ag filler | 12 | | 12 | 12 | 12 |
| | Silicone powder | | 0.1 | 0.1 | | |
| | Silane coupling agent | | | | 0.05 | |
| Measurement results | Heat resistance (weight loss) [%] | Good (1.2) | Good (6.7) | Good (1.2) | Good (4.8) | Good (3.8) |
| | Adhesive strength (normal temperature) [N/mm²] | Good (38.7) | Good (42.5) | Good (40.0) | Good (44.5) | Fair (22.1) |
| | Adhesive strength (200°C) [N/mm²] | Good (8.9) | Good (9.6) | Good (9.2) | Good (11.7) | Poor (1.8) |
| | Strength change ratio (%) | Good (77.0) | Good (77.4) | Good (77.0) | Good (73.7) | Poor (91.9) |
| | Comprehensive evaluation | Excellent | Excellent | Excellent | Excellent | Poor |

As indicated in Table 2, there was obtained the result that even when an additive was added, the resin composition including dicyandiamide as the (B) component has both long-term heat resistance and a low change ratio of adhesive strength. In particular, even when a large amount of a conductive filler is contained, these effects can be obtained. Therefore, the adhesive according to the present invention is extraordinarily useful as a conductive adhesive.

### [Influence by Variation of (A) Component on Long-Term Heat Resistance and Change Ratio of Adhesive Strength]

The long-term heat resistance, adhesive strength (normal temperature and 200°C), and the like of the resin compositions obtained in Comparative Examples 8 to 10 described below were calculated. Then, the results were compared to the result of Example 2.

In Comparative Examples, any one of the followings (indicated as (A') in Table 3) was used instead of the (A) component (F-a type benzoxazine) used in Example 2.
- "H-4" (phenolic resin, Tg (glass transition point) 123°C), manufactured by Meiwa Plastic Industries, Ltd.
- "MEH-7500" (phenolic resin, Tg 170°C) manufactured by Meiwa Plastic Industries, Ltd.
- "MEH-8005" (phenolic resin, Tg 105°C) manufactured by Meiwa Plastic Industries, Ltd.
There was used a 50% solution prepared by diluting "H-4" and "MEH-7500" with butyl carbitol (BC). There was used a 66% solution prepared by diluting "MEH-8005" with BCA.

As the (B) component, "EH-3636AS" was used. As the (C) component, "BMI-1500" was used.

### (Comparative Example 8)

Into a container, there were poured 2.66 parts (solid content: 1.33 parts) of a 50% solution of "H-4," 0.3 parts of "EH-3636AS," and 1 part of "BMI-1500." The mixture was hand-stirred. Thereafter, the obtained product was dispersed using a triple roll mill, thereby to prepare a resin composition θ.

### (Comparative Example 9)

Into a container, there were poured 2.66 parts (solid content: 1.33 parts) of a 50% solution of "MEH-7500," 0.3 parts of "EH-3636AS," and 1 part of "BMI-1500." The mixture was hand-stirred. Thereafter, the obtained product was dispersed using a triple roll mill, thereby to prepare a resin composition 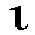 .

### (Comparative Example 10)

Into a container, there were poured 2 parts (solid content: 1.33 parts) of a 66% solution of "MEH-8005," 0.3 parts of "EH-3636AS," and 1 part of "BMI-1500." The mixture was hand-stirred. Thereafter, the obtained product was dispersed using a triple roll mill, thereby to prepare a resin composition κ.

It is noted that the measurement method of long-term heat resistance is the same as that in Example 1 or the like described above.

**[Table 3]**

| Component | Formulation [parts] * Converted into solid content | Example 2 (Resin composition b) | Comparative Example 8 (Resin composition | Comparative Example 9 (Resin composition 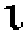 ) | Comparative Example 10 (Resin composition κ) |
|---|---|---|---|---|---|
| (A) | F-a type benzoxazine | 1.33 | | | |
| (A') | H-4 (phenol/Tg 123°C) | | 1.33 | | |
| | MEH-7500 (phenol/Tg 170°C) | | | 1.33 | |
| | MEH-8005 (phenol/Tg 105°C) | | | | 1 |
| (B) | EH-3636AS (DICY) | 0.3 | 0.3 | 0.3 | 0.3 |
| (C) | BMI-1500 (liquid dimer acid-modified) | 1 | 1 | 1 | 1 |
| Measurement results | Heat resistance (weight loss) [%] | Good (5.8) | Poor (16.4) | Good (6.5) | Good (7.4) |
| | Adhesive strength (normal temperature) [N/mm²] | Good (44.5) | Fair (22.9) | Fair (27.0) | Fair (27.1) |
| | Adhesive strength (200°C) [N/mm²] | Good (7.2) | Poor (0.2) | Poor (0.3) | Poor (1.3) |
| | Strength change ratio (%) | Good (83.8) | Poor (99.1) | Poor (98.9) | Poor (95.2) |
| | Comprehensive evaluation | Excellent | Poor | Poor | Poor |

As indicated in Table 3, there was obtained the result that when a compound having in its molecule only an OH group (a compound not having any one of primary to tertiary amines), such as phenolic resin, is used, there is not obtained a resin composition which satisfies all the criteria. In particular, the adhesive strength at 200°C and the change ratio of adhesive strength were lower than the evaluation criteria in all Comparative Examples.

### [Influence by Existence of (D) Component on Long-Term Heat Resistance and Change Ratio of Adhesive Strength]

The long-term heat resistance, adhesive strength (normal temperature and 200°C), and the like of the resin compositions obtained in Examples 13 to 17 and Comparative Examples 11 to 15 described below were calculated.

As the (A) component, a 66% solution prepared by diluting "F-a type benzoxazine" with BCA was used. As the (B) component, "EH-3636AS" or "EH-3842" was used. Also, in some of Comparative Examples, "DDH" was used instead of the (B) component (indicated as (B') in Table 4). As the (C) component, "BMI-1500" was used. As an additive, an Ag filler was used.

As the (D) component, any one of the followings was used.
- "EXA-835LU" (BisA-BisF mixed epoxy) manufactured by DIC Corporation
- "jER871" (dimer acid-modified epoxy) manufactured by Mitsubishi Chemical Corporation
- "Lecy" (liquid cyanate ester) manufactured by Lonza Japan Ltd.

### (Example 13)

Into a container, there were poured 1.33 parts of "F-a type benzoxazine," 0.3 parts of "EH-3636AS," 1 part of "BMI-1500," 0.5 parts of "EXA-835LV," and 0.5 parts of "jER871." The mixture was hand-stirred. Thereafter, the obtained product was dispersed using a triple roll mill, thereby to prepare a resin composition m.

### (Example 14)

Into a container, there were poured 2 parts (solid content: 1.33 parts) of a 66% solution of "F-a type benzoxazine," 0.3 parts of "EH-3636AS," 1 part of "BMI-1500," and 1 part of "EXA-835LV." The mixture was hand-stirred. Thereafter, the obtained product was dispersed using a triple roll mill, thereby to prepare a resin composition n.

### (Example 15)

Into a container, there were poured 2 parts (solid content: 1.33 parts) of a 66% solution of "F-a type benzoxazine," 0.3 parts of "EH-3636AS," 1 part of "BMI-1500," and 1 part of "jER871." The mixture was hand-stirred. Thereafter, the obtained product was dispersed using a triple roll mill, thereby to prepare a resin composition o.

### (Example 16)

Into a container, there were poured 2 parts (solid content: 1.33 parts) of a 66% solution of "F-a type benzoxazine," 0.3 parts of "EH-3636AS," 1 part of "BMI-1500," and 1 part of "Lecy." The mixture was hand-stirred. Thereafter, the obtained product was dispersed using a triple roll mill, thereby to prepare a resin composition p.

### (Example 17)

Into a container, there were poured 2 parts (solid content: 1.33 parts) of a 66% solution of "F-a type benzoxazine," 0.3 parts of "EH-3636AS," 1 part of "BMI1500," 1 part of "jER871," and 12 parts of an "Ag filler." The mixture was hand-stirred. Thereafter, the obtained product was dispersed using a triple roll mill, thereby to prepare a resin composition q.

It is noted that in Examples 13 to 16, the different (D) components are added to the components of Example 2. Also, in Example 17, the (D) component (jER871) and an Ag filler are added to the components of Example 2.

### (Comparative Example 11)

Into a container, there were poured 2 parts (solid content: 1.33 parts) of a 66% solution of "F-a type benzoxazine," 0.3 parts of "EH-3636AS," and 1 part of "EXA-835LV." The mixture was hand-stirred. Thereafter, the obtained product was dispersed using a triple roll mill, thereby to prepare a resin composition λ.

### (Comparative Example 12)

Into a container, there were poured 2 parts (solid content: 1.33 parts) of a 66% solution of "F-a type benzoxazine," 0.3 parts of "EH-3842," and 1 part of "EXA-835LV." The mixture was hand-stirred. Thereafter, the obtained product was dispersed using a triple roll mill, thereby to prepare a resin composition µ.

### (Comparative Example 13)

Into a container, there were poured 2 parts (solid content: 1.33 parts) of a 66% solution of "F-a type benzoxazine," 1 part of "BMI-1500," and 1 part of "EXA-835LV." The mixture was hand-stirred. Thereafter, the obtained product was dispersed using a triple roll mill, thereby to prepare a resin composition v.

### (Comparative Example 14)

Into a container, there were poured 0.3 parts of "EH-3636AS," 1 part of "BMI-1500," and 1 part of "EXA-835LV." The mixture was hand-stirred. Thereafter, the obtained product was dispersed using a triple roll mill, thereby to prepare a resin composition ξ.

### (Comparative Example 15)

Into a container, there were poured 2 parts (solid content: 1.33 parts) of a 66% solution of "F-a type benzoxazine," 1 part of "DDH," 1 part of "BMI-1500," and 1 part of "EXA-835LV." The mixture was hand-stirred. Thereafter, the obtained product was dispersed using a triple roll mill, thereby to prepare a resin composition o.

It is noted that the measurement method of long-term heat resistance is the same as that in Example 1 described above.

**[Table 4]**

| Component | Formulation [parts] * Converted into solid content | Example 13 (Resin composition m) | Example 14 (Resin composition) | Example 15 (Resin composition o) | Example 16 (Resin composition p) | Example 17 (Resin composition q) | Comparative Example 11 (Resin composition λ) | Comparative Example 12 (Resin composition µ) | Comparative Example 13 (Resin composition v) | Comparative Example 14 (Resin composition ξ) | Comparative Example 15 (Resin composition o) |
|---|---|---|---|---|---|---|---|---|---|---|---|
| (A) | F-a type benzoxazine | 1.33 | 1.33 | 1.33 | 1.33 | 1.33 | 1.33 | 1.33 | 1.33 | | 1.33 |
| | EH-3636AS (DICY) | 0.3 | 0.3 | 0.3 | 0.3 | 0.3 | 0.3 | | | 0.3 | |
| (B) | EH-3842 (DICY + accelerator) | | | | | | | 0.3 | | | |
| (B') | DDH (amine-based curing agent) | | | | | | | | | | 1 |
| (C) | BMI-1500 (liquid/dimer acid-modified) | 1 | 1 | 1 | 1 | 1 | | | 1 | 1 | 1 |
| (D) | EXA-835LV (BisA-BisF mixed Ep) | 0.5 | 1 | | | | 1 | 1 | 1 | 1 | 1 |
| | jER871 (dimer acid-modified Ep) | 0.5 | | 1 | | 1 | | | | | |
| | Lecy (liquid cyanate ester) | | | | 1 | | | | | | |
| Additives | Ag filler | | | | | 12 | | | | | |
| Measurement results | Heat resistance (weight loss) [%] | Fair (9.2) | Fair (11.1) | Fair (8.1) | Good (7.8) | Good (2.9) | Good (3.6) | Good (4.4) | Poor (14.6) | Fair (11.5) | Good (6.1) |
| | Adhesive strength (normal temperature) [N/mm2] | Good (41.4) | Good (41.7) | Good (42.1) | Good (45.5) | Good (37.5) | Good (65.5) | Good (60.9) | Good (32.8) | Good (37.6) | Good (58.8) |
| | Adhesive strength (200°C) [N/mm2] | Good (9.1) | Good (10.5) | Good (10.1) | Good (9.5) | Good (7.7) | Good (9.0) | Fair (5.4) | Poor (1.4) | Poor (4.1) | Poor (4.0) |
| | Strength change ratio (%) | Good (78.0) | Good (74.8) | Good (76.0) | Good (79.1) | Good (79.5) | Poor (86.3) | Poor (91.1) | Poor (95.7) | Poor (89.1) | Poor (93.2) |
| | Comprehensive evaluation | Good | Good | Good | Excellent | Excellent | Poor | Poor | Poor | Poor | Poor |

As indicated in Table 4, there was obtained the result that, compared with the ternary system according to the above-described Examples, the resin composition having a quaternary system in which epoxy resin or cyanate ester is added (a system including four components of the (A) to (D) components) satisfies all the evaluation criteria. On the other hand, in Comparative Examples, at least the change ratio of adhesive strength was lower than the evaluation criterion. It is noted that the adhesive strength value at 200°C of Comparative Example 11 is closer to those of Examples. However, cracks had occurred in the obtained cured product. Consequently, the resin composition according to Comparative Example 11 was not able to withstand the use as an adhesive. It is considered that since the resin composition having a rigid molecular structure, like Comparative Example 11, is brittle, cracks are likely to occur.

### [Temperature During Curing and Curing Time]

The adhesive strength when the curing temperature and the curing time were varied was measured for the resin compositions according to Example 3 and Example 15.

Specifically, the resin compositions having similar compositions to those of Example 3 and Example 15 were cured at prescribed temperatures (175°C, 200°C, 225°C, and 250°C) and for prescribed times (15 minutes, 30 minutes, 45 minutes, 60 minutes, and 90 minutes). Then, adhesive strength at normal temperature was measured for each of the obtained cured products. The measurement method used was similar to that in Example 1 or the like. Also, whether or not the resin composition had been cured was determined according to the change of adhesive strength. When the adhesive strength changes to a large extent, a crosslinking reaction is proceeding. That is, it is considered that the resin composition is not completely cured. On the other hand, when the adhesive strength hardly changes (when saturated), it is considered that the resin composition has been cured.

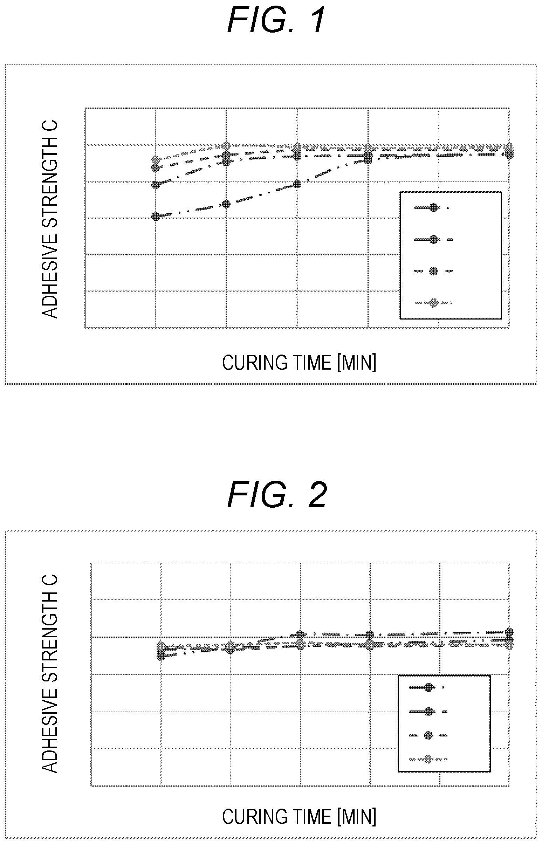

Fig. 1 illustrates results when the resin composition according to Example 3 was used. Fig. 2 illustrates results when the resin composition according to Example 15 was used. As obvious from these results, there was obtained the result that the resin composition including the (A) to (C) components is cured at least at 200°C × 30 minutes. On the other hand, there was obtained the result that the resin composition including the (D) component as well as the (A) to (C) components is cured for a further short time and at a further low temperature (lower than 200°C × 15 minutes).

### [Viscosity of Solid BMI and Liquid BMI]

The viscosity was calculated for the resin compositions obtained in Example 2 and Example 18.

### (Measurement of Viscosity)

The viscosity of the resin composition before curing was measured using an EHD-type viscometer (3° cone/R 9.7 manufactured by Toki Sangyo Co., Ltd.).

### (Example 18)

Into a container, there were poured 2 parts (solid content: 1.33 parts) of a 66% solution of "F-a type benzoxazine," 0.3 parts of "EH-3636AS," and 0.5 parts of "BMI." The mixture was hand-stirred. Thereafter, the obtained product was dispersed using a triple roll mill, thereby to prepare a resin composition r.

**[Table 5]**

| Component | Formulation [parts] * Converted into solid content | Example 2 (Resin composition b) | Example 18 (Resin composition r) |
|---|---|---|---|
| (A) | F-a type benzoxazine | 1.33 | 1.33 |
| (B) | EH-3636AS (DICY) | 0.3 | 0.3 |
| (C) | BMI (solid) | | 0.5 |
| | BMI-1500 (liquid/dimer acid-modified) | 1 | |
| Measurement results | Viscosity (Pa·s/1 rpm) | 10 | 20 |

As indicated in Table 5, the amount of bismaleimides used in Example 2 in which liquid bismaleimides were used is twice that in Example 18. In spite of such a fact, there was obtained the result that Example 2 is low in viscosity.

### [Printing Performance Depending on Whether Solid BMI or Liquid BMI]

The conductivity and printing performance were calculated for the resin compositions obtained in Example 9 and Example 19.

### (Example 19)

Into a container, there were poured 2 parts (solid content: 1.33 parts) of a 66% solution of "F-a type benzoxazine," 0.3 parts of "EH-3636AS," 0.5 parts of "BMI," and 12 parts of an "Ag filler." The mixture was hand-stirred. Thereafter, the obtained product was dispersed using a triple roll mill, thereby to prepare a resin composition s.

### (Measurement of Conductivity)

The resin composition was spread on a screen mask (emulsion thickness: 20 µm, #200 mesh, pattern dimension: 1 mm × 71 mm), thereby to perform screen printing on an alumina substrate. Then, the resin composition was left to stand at 200°C for 30 minutes for curing. Thus, a test piece was obtained. The resistance value and film thickness of the obtained test piece were measured using a digital multimeter and a surface roughness tester. Then, the specific resistance value of the cured resin composition was calculated.

In the measurement results, the specific resistance value of 1 × 10⁻³ Ω·cm or less was evaluated as "Good."

### (Measurement of Printing Performance)

The resin composition was spread on a metal mask having a thickness of 70 µm and a pattern dimension of 1.6 × 0.9 mm. Next, stencil printing was performed with the resin composition on an alumina substrate using a metal squeegee. Then, the resin composition was left to stand at 200°C for 30 minutes for curing.

The presence or absence of rubbing on a pattern of the cured coated film was visually inspected.

In the measurement results, the coated film without rubbing was evaluated as "Good." The coated film with rubbing only on the periphery of a pattern was evaluated as "Fair".

**[Table 6]**

| Component | Formulation [parts] * Converted into solid content | Example 9 (Resin composition i) | Example 19 (Resin composition s) |
|---|---|---|---|
| (A) | F-a type benzoxazine | 1.33 | 1.33 |
| (B) | EH-3636AS (DICY) | 0.3 | 0.3 |
| (C) | BMI (solid) | | 0.5 |
| | BMI-1500 (liquid/dimer acid-modified) | 1 | |
| Additives | AG filler | 12 | 12 |
| Measurement results | Specific resistance value (≦1 × 10⁻³ Ω·cm) | Good | Good |
| | Printing performance | Good | Fair |

As illustrated in Table 6, it became obvious that both of the resin compositions according to Example 9 and Example 19 can have sufficient conductivity. Furthermore, the viscosity of the resin composition can be lowered when liquid bismaleimides are used (Example 9) than when solid bismaleimides are used (Example 19). Therefore, there was obtained the result that even when a conductive filler is added, printing performance is excellent.

As obvious from Examples and Comparative Examples described above, the resin composition including (A) a compound having in its molecule an OH group and any one of primary to tertiary amines, (B) dicyandiamide, and (C) bismaleimides has long-term heat resistance and a low change ratio of adhesive strength.

## Claims

1. A resin composition comprising:
a compound A having in its molecule an OH group and any one of primary to tertiary amines, wherein A is a compound having a benzoxazine backbone;
a compound B being dicyandiamide; and
a compound C being bismaleimides, wherein C is liquid bismaleimides.

2. The resin composition according to any one of claims 1, further comprising a compound D having in its molecule one or more epoxy groups, or cyanate ester.

3. A conductive resin composition comprising the resin composition according to any one of claims 1 to 2 and a conductive filler.

4. An adhesive comprising the resin composition according to any one of claims 1 to 2.

5. A conductive adhesive comprising the resin composition according to claim 3.

6. A paste for forming electrodes comprising the resin composition according to claim 3.

7. A semiconductor device comprising:
a cured product of the resin composition according to any one of claims 1 to 3;
a cured product of the adhesive according to claim 4;
a cured product of the conductive adhesive according to claim 5; or
a cured product of the paste for forming electrodes according to claim 6.

## Patentansprüche

1. Eine Harzzusammensetzung, die folgende Merkmale aufweist:
eine Verbindung A, die in ihrem Molekül eine OH-Gruppe und eines von primären bis tertiären Aminen aufweist, wobei A eine Verbindung ist, die ein Benzoxazin-Grundgerüst aufweist;
eine Verbindung B, die Dicyandiamid ist; und
eine Verbindung C aus Bismaleimiden, wobei C flüssige Bismaleimide sind.

2. Die Harzzusammensetzung gemäß einem der Ansprüche 1, die ferner eine Verbindung D aufweist, die in ihrem Molekül eine oder mehrere Epoxidgruppen oder Cyanat-Ester aufweist.

3. Eine leitfähige Harzzusammensetzung, die die Harzzusammensetzung gemäß einem der Ansprüche 1 bis 2 und einen leitfähigen Füllstoff aufweist.

4. Ein Haftmittel, das die Harzzusammensetzung gemäß einem der Ansprüche 1 bis 2 aufweist.

5. Ein leitfähiges Haftmittel, das die Harzzusammensetzung gemäß Anspruch 3 aufweist.

6. Eine Paste zum Bilden von Elektroden, die die Harzzusammensetzung gemäß Anspruch 3 aufweist.

7. Ein Halbleiterbauelement, das folgende Merkmale aufweist:
ein gehärtetes Produkt der Harzzusammensetzung gemäß einem der Ansprüche 1 bis 3;
ein gehärtetes Produkt des Haftmittels gemäß Anspruch 4;
ein gehärtetes Produkt des leitfähigen Haftmittels gemäß Anspruch 5; oder
ein gehärtetes Produkt der Paste zum Bilden von Elektroden gemäß Anspruch 6.

## Revendications

1. Composition de résine, comprenant:
un composé A présentant, dans sa molécule, un groupe OH et l'une ou l'autre parmi les amines primaires à tertiaires, où A est un composé présentant un squelette benzoxazine;
un composé B qui est la dicyandiamide; et
un composé C qui est des bismaléimides, où C est des bismaléimides liquides.

2. Composition de résine selon l'une quelconque des revendications 1, comprenant par ailleurs un composé D présentant, dans sa molécule, un ou plusieurs groupes époxy, ou un ester de cyanate.

3. Composition de résine conductrice comprenant la composition de résine selon l'une quelconque des revendications 1 à 2 et une charge conductrice.

4. Adhésif comprenant la composition de résine selon l'une quelconque des revendications 1 à 2.

5. Adhésif conducteur comprenant la composition de résine selon la revendication 3.

6. Pâte pour former des électrodes comprenant la composition de résine selon la revendication 3.

7. Dispositif semi-conducteur, comprenant:
un produit durci de la composition de résine selon l'une quelconque des revendications 1 à 3;
un produit durci de l'adhésif selon la revendication 4;
un produit durci de l'adhésif conducteur selon la revendication 5; ou
un produit durci de la pâte pour former des électrodes selon la revendication 6.
